## Europäisches Patentamt
## European Patent Office
## Office européen des brevets

(11) Publication number: **0 153 041**
**A2**

# EUROPEAN PATENT APPLICATION

(21) Application number: 85300584.1

(22) Date of filing: 29.01.85

(51) Int. Cl.⁴: **H 01 L 31/00,** H 01 L 31/02, H 01 L 31/18

(30) Priority: 30.01.84 US 575373

(43) Date of publication of application: 28.08.85 Bulletin 85/35

(84) Designated Contracting States: BE CH DE FR GB IT LI LU NL SE

(71) Applicant: ENERGY CONVERSION DEVICES, INC., 1675 West Maple Road, Troy Michigan 48084 (US)

(72) Inventor: Hanak, Joseph J., 1028 Ridgedale, Birmingham Michigan 48008 (US)

(74) Representative: Boon, Graham Anthony et al, Elkington and Fife High Holborn House 52/54 High Holborn, London, WC1V 6SH (GB)

(54) Improved large area photovoltaic cell and method for producing same.

(57) A large-area photovoltaic cell tolerant of puncture damage to its small-area segments and exhibiting only a proportional loss of electrical output from low resistance current paths formed through those small-area segments. The small-area segments are electrically connected in series in rows that are electrically connected in parallel. Columns of the small-area segments are connected by bridges of semiconductor material simplifying manufacture. The lateral resistance of the semiconducting material electrically isolates the columns from each other. The large-area cell also includes a pressurized sealant that is released when the cell is pierced. The sealant flows through the damaged portion and protects the edges of the puncture from degradation by ambient conditions.

2.

0153041

Active semiconductor layers of thin film photovoltaic cells are, by definition, quite thin, i.e., approximately several hundred to several thousand angstroms thick. While the materials utilized in thin film, large-area photovoltaic devices, especially amorphous silicon alloy materials, are quite durable, their extreme thinness makes small-area segments of a large-area device susceptible to damage such as the formation of low resistance current paths. In the absence of proper photovoltaic device design, low resistance current paths can disproportionately reduce the performance of a large-area device. Even a small number of such low resistance current paths can effectively short circuit an entire photovoltaic cell, thereby degrading or destroying its electrical performance. Low resistance current paths can be created during the fabrication of a photovoltaic cell. Damage may also occur to small-area segments of a large-area photovoltaic device while in place if those segments are punctured by hail, rocks, bullets, or other projectiles. It is highly desirable to have a photovoltaic cell which is (1) insensitive to, or tolerant of, the effects of low resistance current paths, and (2) resistant to puncture damage.

Various solutions to the problem of defect tolerance of large-area devices have been proposed. Some of these solutions including dividing the device into an array of smaller area devices or segments that may be series-connected to enhance voltage output or parallel-connected to enhance current voltage output. Each method of electrical connection of small-area devices has its inherent problems. In another approach, a combined series-parallel array of small-area photovoltaic segments has previously been employed to form a thin film, large-area photovoltaic cell. In a series-parallel array, a plurality of small-area photovoltaic segments are disposed in rows and columns upon a substrate. The small-area photovoltaic segments within each given row are electrically connected in series and those series-connected rows are then electrically connected in parallel. The terms "rows" and "columns", as used herein, designate subgroups of small-area segments within a matrix array. Those small-area segments combine to form a large-area photovoltaic cell. The term "rows" and "columns" as used herein include any grouping of adjacent small-area segments, and accordingly may be used interchangably. For clarity, the series-connected small-area segments will be described in this specification as being aligned in parallel rows, it being understood that they could equally well be described as being aligned in columns. Furthermore, it is not necessary that the rows and columns be oriented at right angles to one another. Other configurations such as diagonal arrangements may be similarly employed.

U.S. Patent No. 4,315,096 to Tyan, et al., entitled Intergrated Array of Photovoltaic Cells Having Minimized Shorting Losses, discloses a series-parallel connected array of small-area segments forming a large-area photovoltaic cell. While the patent to Tyan provides a series-parallel connected large-area photovoltaic cell, the method of fabrication disclosed therein requires repeated, orthogonal scribing of the continuous layer of semiconductor material from which the cell is made. The patent to Tyan offers no solution to the problems resulting from puncture damage to the large area photovoltaic

4.

0153041

cell after installation. It is desirable to eliminate the multiple scribing steps required by the method of Tyan to save time and cost.

U.S. Patent No. 4,281,208 to Kuwano, et al., entitled Photovoltaic Device and Method of Manufacturing Thereof, discloses a series-connected array of photovoltaic cells. In some embodiments disclosed, the lateral resistance of the thin films of semiconductor is used to isolate adjacent small-area segments that are formed from a continuous sheet of semiconductor material. Kuwano does not disclose any parallel-series interconnection nor any means of protecting the array from puncture damage.

The problems described are solved in the present invention by use of one or more semiconductor "bridges" that electrically contact a plurality of electrode members within a given column and the insulating substrate on which the array is formed. In this manner, the number of processing steps, including scribing, is reduced, reducing the likelihood of damage to the small-area segments during their formation and processing.

The large-area photovoltaic cell may also include a pressurized layer of semi-solid sealant material, such as a silicone compound, disposed immediately beneath the electrically insulating substrate. Puncture or other mechanical damage to the large area cell releases the sealant which flows into the damaged area and protects the edges of the puncture from ambient conditions.

Figure 1 depicts a cross-sectional, fragmentary view of a small-area photovoltaic segment fabricated in accordance with the principles of the instant invention, and including an insulating substrate, first and second electrodes, a plurality of p-i-n semiconductor layers, a transparent conductive oxide layer and a grid.

Figure 2A is a top plan view of a large-area photovoltaic cell that is divided into a plurality of the small-area segments, such as shown in Figure 1, said small-area segments being electrically connected in the series-parallel arrangement of the instant invention.

Figure 2B is a circuit diagram illustrating the manner in which a low resistance current path through one of the small-area segments of Figure 2A affects the series-parallel electrical connection of the instant invention.

Figure 3 is a cross-sectional view taken along line 3-3 of Figure 2A illustrating the manner in which the second electrode of one small-area segment overlays and electrically interconnects the adjacent small-area segment in the same row.

Figure 4 is a cross-sectional view taken along line 4-4 of Figure 2A illustrating the manner in which the semiconductor layers of small-area segments bridge the spacing between adjacent columns.

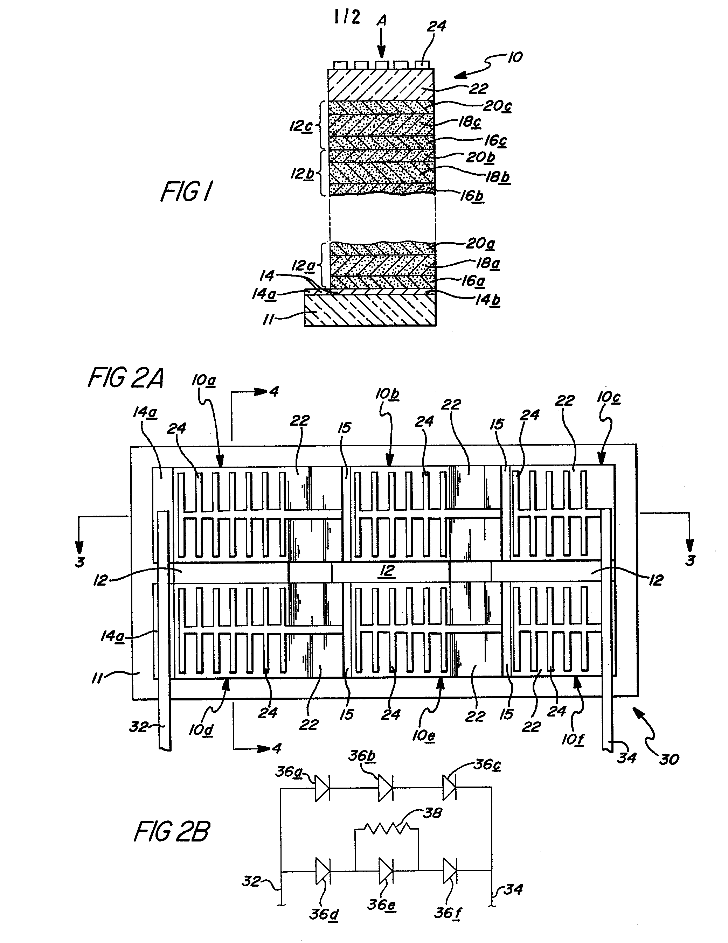

Figure 1, illustrates a small-area segment of the type that, according to the teaching of the instant invention, may be interconnected to form an improved large-area photovoltaic cell. A small-area photovoltaic segment 10 is formed of a substrate 11, a first electrode 14, plurality of successively deposited p-i-n semiconductor alloy layers 12, a transparent conductive oxide second electrode 22, and a grid pattern 24. Figure 1 shows a typical p-i-n type small-area photovoltaic segment made up of individual p-i-n type sub-cells 12a, 12b and 12c. Below the lowermost sub-cell 12a, electrically insulating substrate 11 provides support to, and electrically isolates small-area segment 10 from, the adjacent small-area segments into which the large-area photovoltaic cell is divided. Substrate 11 must have at least one electrically insulating surface upon which the layers that combine to form small-area segment 10 disposed. Accordingly, the substrate may be formed from materials such as glass, organic polymers such as polyesters, polyimides, vinyls, or electrically conductive materials upon which an insulating layer has been formed. One substrate material having particular utility in the practice of the instant invention is .005 to .0125 cm thick stainless steel upon which an insulating polyimide coating of at least 1 micron thickness is applied. Other substrate materials may be used without departing from the spirit or scope of the instant invention provided only that they have at least one electrically insulating surface and are capable of providing dimensional support and stability to the photovoltaic segments subsequently formed thereupon.

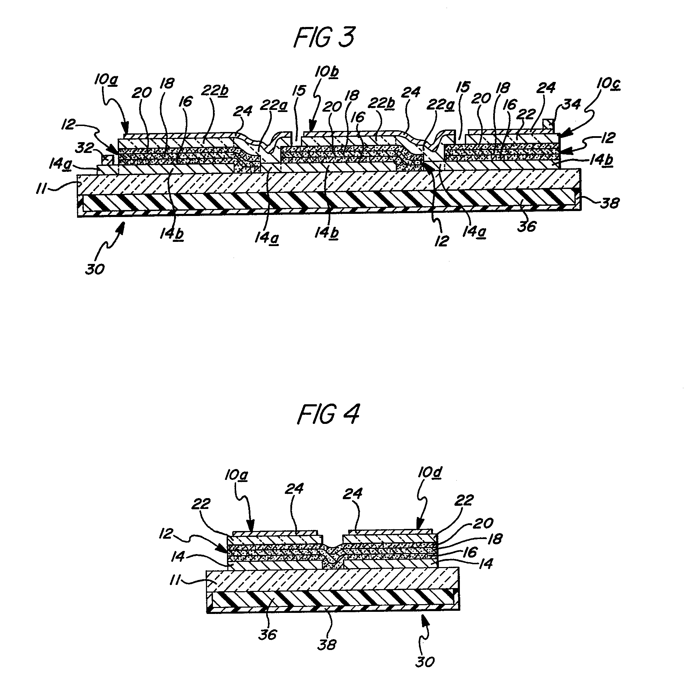

Disposed on top of substrate 11 and beneath first sub-cell 12a is a small-area electrode 14. Electrode 14 is referred to as being of "small-area" because it defines the surface area of the bottom surface of small-area photovoltaic segment 10 and covers a surface area substantially smaller than the surface area covered by the large-area photovoltaic cell of the instant invention. First small-area electrode 14 is formed of an electrically conductive material and provides electrical access to the thin film semiconductor layers deposited on it. Accordingly, electrode 14 is preferably formed of a material exhibiting high electrical conductivity, i.e. a metal. However, in some applications a transparent electrode material will be favored, for example, when substrate 11 is transparent and small-area photovoltaic segments 10 are illuminated through the substrate.  It will be noted that while a major portion 14b (see Figures 1 and 3) of first electrode 14 is covered by the semiconductor layers of the first sub-cell 12a, a minor portion 14a of that first electrode 14 is left exposed.  This configuration permits series interconnection of small-area photovoltaic segments 10 that form the improved large-area photovoltaic cell described herein.

Sub-cells 12a, 12b and 12c are stacked on top of major portion 14b of electrode 14.  Each of sub-cells 12a, 12b and 12c are fabricated with an amorphous semiconductor body containing, in the preferred embodiment, at least a silicon or germanium alloy.  Each of the semiconductor bodies includes an n-type conductivity semiconductor layer 20a, 20b and 20c, an intrinsic semiconductor layer 18a, 18b and 18c, and a p-type conductivity semiconductor layer 16a, 16b and 16c.  As illustrated, sub-cell 12b is an intermediate sub-cell and, as indicated in Figure 1, additional intermediate sub-cells may be stacked on top of the illustrated sub-cells without departing from the spirit or the scope of the present invention.

On top of uppermost sub-cell 12c a second small-area electrode 22 is deposited.  In the preferred embodiment, small-area photovoltaic segment 10 is illuminated from the top surface thereof (i.e., in the direction of arrow A in Figure 11), and therefore second electrode 22 is formed from a light transmissive, electrically conductive material such as indium tin oxide.  A metallic electrode material may be employed if small-area segment 10 is to be illuminated from the substrate side.  A high conductivity current collecting grid 24 may be optionally applied on transparent conductive oxide layer 22 of the small-area segment to decrease resistance to flow of electrical current if the small-area segment is relatively large in area, or if the electrical conductivity of transparent conductive oxide electrode layer 22 is too low. Grid 24 shortens the carrier path through the transparent conductive oxide of second electrode layer 22, thereby increasing the conduction efficiency. Although the term "small-area photovoltaic segment" has been applied to the structure illustrated in Figure 1, it should be noted that small-area segment 10 is an independent photovoltaic cell. First electrode 14, semiconductor layers 16a, 18a, 20a, 16b, 18b, 20b, 16c, 18c, 20c and second electrode 22 cooperate to form the small-area photovoltaic cell. The term "photovoltaic segment" has been utilized to describe this small-area cell to distinguish it from the term "large-area photovoltaic cell" that is used herein to refer to the improved large-area cell that is divided into the plurality of series-parallel connected small-area segments in accordance with the principles of the instant invention.

While small-area segment 10 illustrated in Figure 1 is a stacked assembly of p-i-n type photovoltaic sub-cells, the instant invention is obviously not limited to that structure, but may be utilized with photovoltaic segments of any configuration, provided they are capable of producing photo-generated electrical current. For example, the semiconductor layers of small-area photovoltaic segment 10 could be replaced with layers having an n-i-p configuration, a p-n configuration, an n-p configuration, a Schottky barrier, combinations thereof or any other photovoltaic structure known to those skilled in the art.

Figure 2A illustrates, in plan view, a large-area photovoltaic cell 30 structured in accordance with the principles of the instant invention. Large-area cell 30 includes a plurality of small-area photovoltaic segments 10a-10f interconnected in a series-parallel arrangement. For simplicity, large-area cell 30 illustrated in Figure 2A is shown as divided into six small-area segments while in reality a larger number of small-area segments are generally preferred.

Each small-area photovoltaic segment 10a-10f is generally similar to small-area segment 10 illustrated in Figure 1. The small-area segments of large-area cell 30 are disposed upon insulating substrate 11, as previously described. Each small-area segment includes an upper second small-area electrode 22 forming one terminal of each small-area segment. In this embodiment, large-area photovoltaic cell 30 is illuminated from the second electrode side, and accordingly, electrodes 22 are formed of a transparent conductive oxide material such as indium tin oxide. Immediately beneath second electrode 22 of small-area segments 10 is active semiconductor body 12. It is a notable feature of this invention that a separate semiconductor body 12 need not be provided for each small-area segment, but rather, a single semiconductor body may be provided including bridges of semiconductor material that may span two or more small-area segments within a given column of the large-area photovoltaic cell. As shown in Figure 2A, portions of semiconductor bridge 12 are visible between adjacent pairs of small-area segments, such as between small-area segments 10a-10d, 10b-10e, 10c-10f, thereby forming the three columns of the illustrated large area photovoltaic cell 30. Each small-area segment also includes first small-area electrode 14 disposed between substrate 11 and bridge of semiconductor material 12.

First small-area electrode 14 and second small-area electrode 22 are of generally similar dimensions although they are laterally offset slightly relative to one another to provide for the electrical-interconnection, in series, of small-area segments 10. Because of this lateral offset, a small portion of the exposed surface of first electrode 14, referred to herein as minor portion 14a, is not covered by semiconductor material and hence is visible in the plan view of the large-area photovoltaic cell 30 shown in Figure 2A.

Each small-area segment 10a-10f may also include grid pattern 24 operatively disposed on top of the second small-area electrode 22. Grid pattern 24 is formed of a high conductivity material, such as a metal, and serves to shorten the current pattern through transparent conductive oxide layer 22, thereby decreasing the internal resistance to the flow of current through large-area photovoltaic cell 30. The grid pattern may be formed by any method well known in the art, for example, a silver paste may be silk screened onto the small-area segments of the large-area cell in a desired pattern, or electroplating may be utilized to deposit a metallic grid pattern.

Small-area segments 10a-10f into which large-area photovoltaic cell 30 is divided, are arrayed in rows and columns. Small-area segments 10a, 10b and 10c form one row, while small-area segments 10d, 10e and 10f form a second row. The two rows of series-connected small-area segments are electrically connected in parallel by bus bars 32 and 34. First bus bar 32 contacts the exposed minor portion 14a of the first electrode of small-area segments 10a and 10d, while second bus bar 34 contacts the second electrodes 22 of small-area segments 10c and 10f. In this manner, the two rows of series-connected small-area segments 10 are electrically
connected in parallel.  If the large-area photovoltaic cell 30
includes a greater number of rows of series connected
small-area segments 10, those rows would be similarly contacted
and electrically connected by bus bars 32 and 34.

      Figure 2B represents a circuit diagram which is a '
model for explaining the electrical behavior of large-area
photovoltaic cell 30 illustrated in Figure 2A.  Individual
small-area photovoltaic segments 10a-10f are represented by
photovoltaic diodes 36a-36f.  Diodes 36a-36c represent the
first row of series-connected small-area segments 36a-36c,
while diodes 36d-36f represent the second row of
series-connected small-area segments 36d-36f.  The two
series-connected rows of diodes 36a-36c and 36d-36f are
electrically connected in parallel by bus bars 32 and 34.  A
low resistance current path, such as a short or shunt defect,
can be represented as a resistance in parallel with one of
photovoltaic diodes 36.  For example, photovoltaic diode 36e,
which generally corresponds to small-area segment 10e of Figure
2A, is shown as having a resistor 38 placed in parallel with
it.  Resistor 38 thus provides a low resistance current path
around photovoltaic diode 36e.  Because of the low resistance,
small-area segment 10e (represented by photovoltaic diode 36e)
is unable to contribute voltage or current to the second row of
small-area segments.  In other words, the total electrical
output of the second row of small-area segments is supplied by
the photovoltaic diodes 36d and 36f, and therefore, the total
output voltage of the second row of small-area segments will be
approximately one third lower than that of the first row of
small-area segments.  Since the two rows of small-area segments are electrically connected in parallel, the net effect of the
low resistance current path upon the total output voltage of
the large-area cell will be less significant than if the first
and second rows of small-area segments were electrically
connected in series. More particularly, the loss in output
voltage due to low resistance current paths will be
proportional to the number of defective small-area segments.
As the model is extrapolated to represent an entire large-area
photovoltaic cell 30, it will be understood that a large number
of rows of series connected small-area segments are present,
and accordingly, a reduction in the output voltage of only one
or two rows will have a negligible effect upon the output
voltage of the total number of series-connected rows of
small-area cells which form the large-area photovoltaic cell.

Referring now to Figure 3, a cross-sectional view
taken along line 3-3 of Figure 2A illustrates the electrically
connected rows of small-area segments of the large-area
photovoltaic cell 30. Shown in cross-section is insulating
substrate 11 and three series connected small-area photovoltaic
segments 10a-10c disposed thereupon. Each of the small-area
segments includes first small-area electrode 14, layers of
semiconductor material 12, second small-area electrode 22, and
grid pattern 24. As previously discussed, first electrode 14
and second electrode 22 are both similarly sized, but are
generally laterally offset relative to one another. More
specifically, while a major portion of first electrode 14b and
major portion of the second electrode 22b are generally
coextensive, each of the electrodes include minor portions 14a
and 22a, respectively, which effect electrical connections
between adjacent small-area segments in a row.

13.

0153041

In order to establish a series connection of adjacent small-area segments 10a-10c in the first row, it is necessary that second small-area electrode 22 of first small-area segment 10a be electrically connected to second small-area electrode 14 of second small-area segment 10b, which small-area segment 10b, in turn, has its second small-area electrode 22 electrically connected to first small-area electrode 14 of third small-area segment 10c. In the embodiment of the instant invention illustrated in Figure 3, such a series connection is established by depositing second electrode 22 of a first small-area segment 10a so that minor portion 22a thereof overlaps and establishes electrical contact with minor portion 14a of first electrode 14 of the adjacent small-area segment in the row, i.e. segment 10b. Second electrode 22 of the second small-area segment 10b is likewise deposited so that the minor portion thereof 22a overlaps and establishes electrical contact with minor portion 14a of the first electrode of adjoining third small-area segment 10c. In this manner, series electrical connection of the first row of small-area segments 10a, 10b and 10c is established. It should be noted that care must be taken to prevent second electrode 22 of a given small-area segment (for example 10a) from electrically contacting second electrode 22 of the adjoining series-connected small-area segments (for example 10b). Such electrical contact may be prevented by any method well known to those skilled in the art, as for example, by the use of deposition masks and etches to restrict the extent of second electrode 22 or by the use of electrical resist material to prevent such electrical contact.

14.

0153041

In the illustrated embodiment, second electrodes 22 are deposited without regard for the prevention of spurious electrical contact, and the device is then scribed to create a channel 15, which electrically isolates the electrode segments. It will also be noted from an inspection of the figure, that semiconductor material 12 "fills in" the spaces between first electrodes 14 of adjoining series-connected small-area segments (e.g. 10a and 10b). While such contact is not essential for the operation of the instant invention, it is notable that no adverse electrical effects result from such contact. The lateral electrical resistance of the semiconductor material is relatively high, therefore, a spacing of approximately .02 mm between first electrodes 14 of segments 10 is sufficient to render them electrically isolated, even though they are both in contact with a common semiconductor layer. Likewise, semiconductor material 12 "fills in" the space between first electrodes 14 of adjacent small-area segments in a column (e.g. 10a and 10d). The lateral electrical resistance of the semiconductor material also serves to isolate electrodes in a column, thereby reducing by at least half the amount of scribing required in the patent to Tyan et al.

In an alternative embodiment of the instant invention, electrical contact is established between the adjacent small-area segments by means of an electrical conductor which extends from second electrode 22 of a first small-area segment to minor portion 14a of the first electrode 14 of an adjacent small-area segment. Such electrical conductors may take the form of metallic wires or foils, or be vacuum deposited or electroplated metallic members.

Also shown in Figure 3 is first bus bar 32 that electrically contacts minor portion 14a of the first electrode of first small-area segment 10a and second bus bar 34 that electrically contacts the second electrode 22 of the third small-area segment 10c. It should be noted that the specific arrangement of the bus bars, described hereinabove, is not , required by the concepts disclosed in the instant invention. It may be desirable in some cases to extend second electrode 22 of that small-area segment 10c to insulating substrate 11, ' thereby establishing electrical contact to bus bar 34 thereupon. Other similar modifications of the bus bar system may likewise be made in keeping with the spirit of the instant invention.

Figure 3 illustrates still another feature of the instant invention. Disposed upon the surface of insulating substrate 11, directly opposite the surface thereof upon which small-area photovoltaic segments 10a-10c are disposed, is a layer of sealant material 36 which is retained in pressurized contact with substrate 11 by an encapsulating layer 38. Sealant material 36 is a semi-solid, electrically insulating, air and moisture resistant material such as a silicone or organic resin. In the event of puncture damage to a small-area segment 10 of large-area photovoltaic cell 30, the sealant material 36 oozes through the punctured portion effectively sealing off the edges of the puncture. In this manner electrical insulation is provided and oxidation or corrosion of the damaged edges due to exposure to ambient conditions is prevented. Use of this sealant layer 36 thereby renders the large-area photovoltaic device 30 relatively insensitive to puncture damage. It may be desirable, in some cases, to affix

0153041

portions of encapsulant layer 38 to substrate 11, mechanically by welding, gluing, riveting or some such method. In this manner, a "quilted" configuration is provided, that aids in retaining sealant material 36 in uniform contact with substrate 11. In a similar manner, encapsulant layer 38 may be attached to the substrate so as to form a plurality of discrete pockets or cells that function to retain the sealant material in contact with the substrate.

Figure 4 is a cross-sectional view of large-area photovoltaic cell 30 taken along line 4-4 of Figure 2A, showing sealant material 36, encapsulant layer 38, electrically insulating substrate 11, and two small-area segments 10a and 10d as disposed in one column of the large-area cell 30. First electrodes 14 of small-area segments 10a and 10d are disposed immediately on top of insulating substrate 11. Extending across both first electrodes 14, as well as the portion of the underlying substrate material 11 therebetween, is a bridge of semiconductor material 12, which is the active photovoltaic (i.e. current generating) element of small-area segments 10a and 10d. In the embodiment illustrated in Figure 4, semiconductor bridge 12 is shown as comprised of p-type semiconductor layer 16, intrinsic layer 18 and n-type layer 20. It is a notable feature of the present invention that semiconductor bridge 12 extends between two first electrodes 14 of the small area segments 10a and 10d. The use of a semiconductor bridge is possible because of the relatively high lateral resistivity of the thin film semiconductor material. It should be kept in mind that the vertical dimensions in the figures have been exaggerated for purposes of illustration and that the thickness of the semiconductor bridge 12 will generally be less than a micron, while the spacing between adjacent small area segments 10a and 10d will be significantly greater. Therefore, the individual small-area segments of the photovoltaic cell are electrically isolated, even though common semiconductor bridges 12 are present.

claims

0153041

1. A large-area photovoltaic cell (30), formed on an electrically insulating substrate (11), including a plurality of small-area photovoltaic segments (10a, 10b, 10c, 10d, 10e, 10f) arranged in a plurality of rows and columns, said segments (10a, 10b, 10c, and 10d, 10e, 10f) in each of said rows being electrically connected in series and said rows being electrically connected in parallel, including a plurality of discrete first small-area electrodes (14) formed on said substrate (11) electrically isolated from one another, each first electrode (14) having a major portion (14b) in contact with a discontinuous layer of photoresponsive semiconductor material (12) and a minor portion (14a) in contact with a second electrode (22), and a plurality of second small-area electrodes (22) electrically isolated from one another, each said second electrode (22) overlying the major portion (14b) of one of said first electrodes (14) and electrically contacting the minor portion (14a) of an adjacent segment in the same row to establish a series connection, bus bars (32, 34) at the ends of said rows for establishing parallel connection of said rows, characterized in that said semiconductor layer (12) contacts said substrate (11) between said first electrodes (14) in each said row and column.

2. The large-area photovoltaic cell of claim 1 characterized in that the discontinuous layer of semiconductor material includes at least one layer of an amorphous silicon alloy.

3. The large-area photovoltaic cell of claim 1 characterized in that the discontinuous layer of semiconductor material includes at least one layer of an amorphous germanium alloy.

4. The photovoltaic cell of claim 1 characterized in that the discontinuous layer of semiconductor material includes coextensive layers (20c, 18c, 16c) of p-type, intrinsic, and n type material.

5. The photovoltaic cell of claim 1 characterized in that sealing means for isolating punctured portions of the large-area cell from ambient conditions is disposed on the surface of said substrate (11) opposite the surface bearing said first electrodes (14).

6. The photovoltaic cell of claim 5 characterized in that said sealing means includes a layer of sealant material (36) disposed on the surface of said substrate (11) opposite the surface bearing said first electrodes (14), said sealant (36) being maintained in pressurized contact with said substrate (11) by an encapsulating member (38).

7. A method of manufacturing a large-area photovoltaic cell formed of a plurality of small-area segments arranged in a plurality of rows and columns, said segments in each of said rows being electrically connected in series and said rows being electrically connected in parallel, characterized in:

deposiding a plurality of first small-area, mutually isolated electrodes arranged in rows and columns on an electrically insulating substrate, each first electrode being divided into a major portion and a minor portion;

depositing a discontinuous layer of photoresponsive semiconductor material overlying said major portions of said first electrodes and in contact with said substrate exposed between said adjacent first electrodes in at least one row and at least one column;

depositing a plurality of second small-area, mutually isolated electrodes, each second electrode overlying said major portion of one of the underlying first electrodes and contacting said semiconductor layer and an adjacent minor portion of a said first electrode in a row to connect in series two said small-area segments; and

depositing electrical contacts along the respective ends of said rows to connect in parallel said rows of small-area segments.

8.   The method of claim 7 characterized in applying sealing means to said substrate on a surface opposite said surface bearing said first small-area electrodes for isolating punctured portions of the cell from ambient conditions.

9.   The method of claim 8 characterized in that applying sealing means includes applying a layer of a sealant selected from the group consisting essentially of silicones, organic resins, rubber and combinations thereof.

10.   The method of claim 9 further characterized in applying an encapsulating member over said sealant to maintain said sealant in pressurized contact with said substrate.

11.   The method of claim 7 wherein said substrate is an elongated web, further characterized in continuously advancing the elongated web through a coating station for depositing said semiconductor layer.

12.   The method of claim 11 further characterized advancing said elongated web through a glow discharge apparatus.

0153041

FIG 1

1/2   A   24   10

12c   20c   18c   16c   20b   18b   16b   22

12b

20a   18a   16a   14b

14   12a

14a

11

FIG 2A

10a   4   10b   22   22   10c

14a   24   24   22   15   24   22   15   24   22

3   12   12   3

14a   12

11   32

10d   24   22   15   24   22   15   22   24   10f   30

34   10e

4

FIG 2B

36a   36b   36c

38

32   34

36d   36e   36f

0153041

2/2

FIG 3

FIG 4